# DEMANDE DE BREVET EUROPEEN

(11) **EP 1 302 559 A1**
(43) Date de publication de la demande: **16.04.2003**
(21) Numéro de dépôt: 02292521.8
(22) Date de dépôt: 14.10.2002
(51) Int. Cl.: C23C 16/06, C23C 16/04, C23C 10/06, C23C 16/12, B21D 47/00

(54) **Procédé de protection par aluminisation de pièces métalliques constituées au moins en partie par une structure en nid d'abeilles**

(30) Priorité: 16.10.2001 FR 0113313
(71) Demandeur: Snecma Moteurs, 75015 Paris (FR)
(72) Inventeur: Fournes, Jean-Paul, 91490 Dannemois (FR); Leger, Jacques, 77380 Combs-la-Ville (FR); Richin, Catherine, 91410 Roinville sous Dourdan (FR)
(74) Mandataire: Joly, Jean-Jacques

(57) **Abrégé**

Au moins un précurseur gazeux du dépôt à réaliser comprenant un composé de l'aluminium est amené avec l'aide d'un gaz porteur au contact des surfaces de la pièce disposée dans une enceinte (21). Le gaz porteur est choisi parmi l'hélium et l'argon et la pression dans l'enceinte est choisie de manière que le libre parcours moyen des molécules de gaz porteur soit au moins deux fois supérieur à celui des molécules d'argon sous pression atmosphérique. Le procédé convient notamment pour l'aluminisation de secteur d'anneau de turbine basse pression d'une turbomachine, muni d'un revêtement abradable en nid d'abeilles.

## Description

### Arrière-plan de l'invention

L'invention concerne la protection contre l'oxydation à haute température de pièces métalliques constituées au moins en partie par une structure en nid d'abeilles.

Le domaine d'application de l'invention est plus particulièrement celui de la protection de revêtements abradables en nid d'abeilles formés sur des pièces de turbine basse pression dans des turbomachines. Le domaine d'application s'étend toutefois à toutes pièces aéronautiques en nid d'abeilles qui doit être protégée contre la corrosion par oxydation à haute température.

Dans une turbine basse pression de turbomachine, des joints d'air sont formés entre les sommets d'aubes rotatives et un anneau de turbine fixe qui les entoure et entre les extrémités libres des aubes fixes et un anneau de rotor qui leur fait face, de manière à s'opposer au passage direct d'air dans les intervalles entre les sommets des aubes mobiles ou fixes et les parties annulaires fixes ou mobiles situées en regard. Il est connu de munir les parties fixes d'un revêtement abradable qui peut être formé par une structure métallique en nid d'abeilles fixée par brasage, avec des axes d'alvéoles situés sensiblement radialement. Les parties mobiles peuvent pénétrer sur une partie de la hauteur des alvéoles, par l'intermédiaire des bords des sommets des aubes mobiles ou de parties en saillie, ou léchettes portées par le rotor.

Bien que réalisées en alliages métalliques ayant une bonne tenue aux températures élevées, de telles structures en nid d'abeilles sont sujettes à détérioration par oxydation. En effet, la stagnation de gaz de combustion très chauds dans les alvéoles produit une corrosion susceptible d'entraîner une destruction localisée du revêtement en nid d'abeilles. Il en résulte l'apparition de fuites en périphérie de l'anneau de turbine ou du rotor, avec formation de points chauds et diminution importante du rendement de la turbine. Le remplacement du revêtement abradable en nid d'abeilles nécessite l'immobilisation de la turbine, ce qui représente un coût très élevé lorsqu'il doit être effectué fréquemment.

Un procédé de protection couramment utilisé est l'aluminisation par dépôt en phase vapeur. Ce procédé est bien connu ; on pourra en particulier se référer au document FR 1 433 497. Il consiste à placer une ou plusieurs pièces à protéger dans une enceinte dans laquelle circule un mélange gazeux comprenant un composé de l'aluminium, tel qu'un halogénure et un gaz de dilution ou gaz porteur. L'halogénure est produit par réaction entre un halogène par exemple chlore ou fluor, et un donneur métallique contenant de l'aluminium, par exemple un alliage métallique d'aluminium avec un ou plusieurs des constituants métalliques du matériau des pièces à protéger. Le gaz de dilution assure la dilution et l'entraînement du mélange gazeux pour amener l'halogénure au contact des pièces afin de former le dépôt souhaité à la surface de celles-ci. Le gaz de dilution couramment utilisé est l'argon. L'hydrogène est également mentionné dans le document FR 1 433 497 précité, mais son utilisation est très difficile en pratique en raison de sa dangerosité.

Dans le cas de pièces fixes de turbine basse pression, l'aluminisation doit être réalisée après brasage du revêtement abradable en nid d'abeilles sur les pièces, le brasage ne pouvant être réalisé après aluminisation.

Le procédé classique d'aluminisation par dépôt en phase vapeur permet certes la formation d'une couche de protection satisfaisante à la surface externe des pièces, mais ne permet pas de former une telle couche protectrice jusqu'au fond fermé des alvéoles. Or, une protection contre l'oxydation à haute température est requise non seulement au voisinage des ouvertures des alvéoles, mais également jusqu'au fond où des gaz chauds de combustion peuvent stagner.

### Objet et résumé de l'invention

L'invention a pour but de proposer un procédé permettant de réaliser une protection par aluminisation sur l'ensemble des surfaces exposées de pièces formées au moins en partie par une structure en nid d'abeilles, en particulier sur la totalité des faces des alvéoles de cette structure.

Ce but est atteint grâce à un procédé selon lequel au moins un précurseur gazeux du dépôt à réaliser comprenant un composé de l'aluminium est amené avec l'aide d'un gaz porteur au contact des surfaces de la pièce disposée dans une enceinte, procédé dans lequel, conformément à l'invention, le gaz porteur est choisi parmi l'hélium et l'argon et la pression dans l'enceinte est choisie de manière que le libre parcours moyen des molécules de gaz porteur soit au moins deux fois supérieur à celui des molécules d'argon sous pression atmosphérique.

L'allongement du libre parcours moyen des molécules de gaz porteur permet une pénétration plus aisée dans les alvéoles de la structure en nid d'abeilles et donc permet d'amener les molécules de précurseur gazeux au contact des faces internes des alvéoles, jusqu'au fond de celles-ci. De la sorte, l'intégralité des surfaces de la pièce est aluminisée, donc protégée, ce qui permet d'accroître considérablement sa durée de vie.

Selon un mode de réalisation de l'invention, l'hélium est utilisé comme gaz porteur et le procédé peut être réalisé sous pression atmosphérique, ou sous une pression inférieure à la pression atmosphérique.

Selon un autre mode de réalisation de l'invention, l'argon est utilisé comme gaz porteur et le procédé est avantageusement réalisé sous une pression au plus égale à 50 kPa, de préférence au plus égale à 25 kPa.

### Brève description des dessins

L'invention sera mieux comprise à la lecture faite ci-après à titre indicatif mais non limitatif, en référence aux dessins annexés sur lesquels :
- la figure 1 est une vue en coupe méridienne très schématique d'une partie de turbine basse pression d'une turbomachine ;
- la figure 2 est une vue partielle en perspective d'un secteur d'anneau de la figure 1 ; et
- la figure 3 est une vue très schématique d'une installation permettant la mise en oeuvre d'un procédé selon l'invention.

### Description détaillée de modes de réalisation

Des modes de réalisation de l'invention seront décrits ci-après dans le cas de l'application du procédé à la formation de couche de protection pour des secteurs d'anneau portés par des aubes fixes dans une turbine basse pression de turbomachine. Il apparaîtra immédiatement que le procédé convient pour des secteurs d'anneau fixe de turbine basse pression munis d'une structure abradable en nid d'abeilles, ainsi que pour toute pièce métallique, en particulier toute pièce aéronautique formée au moins en partie d'une structure en nid d'abeilles.

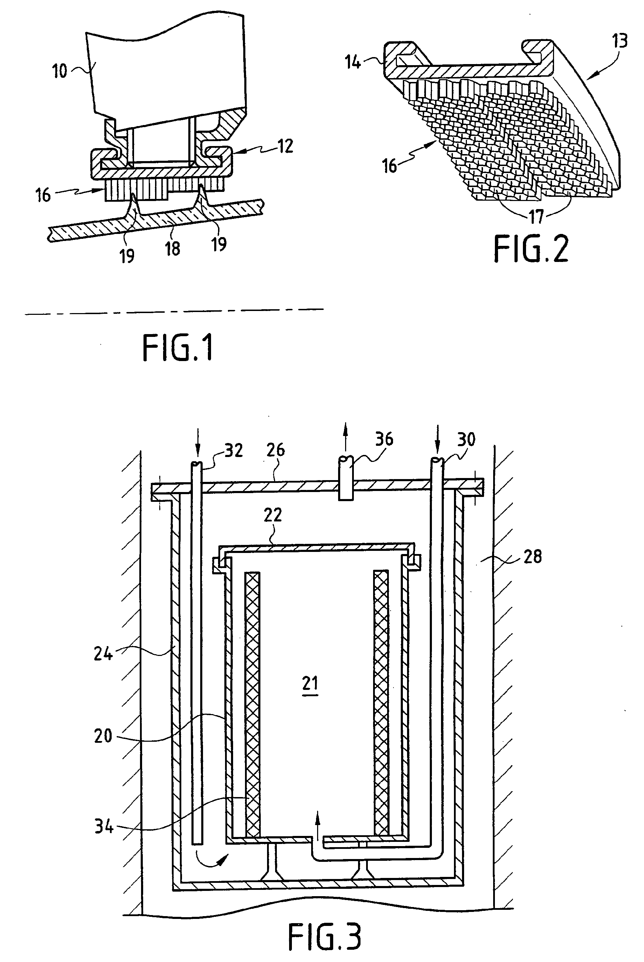

Dans une turbine basse pression telle que montrée très schématiquement en coupe sur la figure 1, les aubes fixes de distribution d'air 10 ont leur extrémité libre engagées sur un anneau 12 formé de secteurs juxtaposés. Chaque secteur d'anneau 13 (figure 2) comprend un secteur de virole 14 muni, du côté intérieur, d'une structure en nid d'abeilles 16.

Le secteur de virole 14 est en un matériau métallique, par exemple un superalliage à base nickel ou cobalt tel que "HA214" (NC16Fe) ou "Hastelloy X" (NC22FeD) ou "HA188" (KCN22W). La structure en nid d'abeilles 16 est également en matériau métallique, par exemple en un superalliage à base cobalt ou à base fer tel que "HA214" et est brasée sur le secteur de virole 14 ou directement sur le distributeur de turbine.

En coupe (figure 1), la structure 16 a un profil étagé qui correspond approximativement à celui de la partie annulaire du rotor 18 de la turbomachine située en regard. Le rotor 18 présente des parties en saillie 19, ou léchettes de labyrinthe, qui, lors du fonctionnement de la turbomachine, pénètrent dans la structure en nid d'abeilles 16 formant revêtement abradable de l'anneau 12.

Les alvéoles 17 de la structure en nid d'abeilles 16 ont leurs axes dirigés sensiblement radialement. A titre indicatif, la hauteur des alvéoles 17 peut être de 5 à 20 mm et la profondeur de pénétration des léchettes 19 dans la structure en nid d'abeilles peut être de 2 à 3 mm.

La combinaison des configurations des léchettes 19 et de la structure abradable 16 permet de former un joint périphérique s'opposant au passage direct des gaz de combustion dans l'intervalle entre les aubes 10 et l'anneau 12. La température élevée des gaz, pouvant dépasser 1000°C, rend nécessaire la formation d'une protection contre l'oxydation à haute température sur les surfaces exposées des secteurs d'anneau, y compris sur les parois internes des alvéoles 17.

Une telle protection est formée par un procédé selon l'invention en utilisant par exemple l'installation d'aluminisation en phase vapeur illustrée par la figure 3.

Cette installation comprend une boîte 20 fermée par un couvercle 22 de façon non étanche et supportée à l'intérieur d'un pot 24. Ce dernier est obturé de façon étanche par un couvercle 26 et est disposé dans un four 28.

Une canalisation 30 alimente l'enceinte 21 définie par la boîte 20 en gaz porteur (ou gaz de dilution). Le même gaz est injecté dans le pot 24, à l'extérieur de la boîte 20, par une canalisation 32. Ce gaz de balayage est recueilli par une canalisation 36, à travers le couvercle 26.

A l'intérieur de la boîte 20 est disposé un donneur 34 sous forme par exemple de granulés ou poudre. Le donneur est généralement constitué par un alliage d'aluminium et d'un ou plusieurs métaux constitutifs des pièces à aluminiser. Un activateur permettant de former un halogénure avec le donneur est également introduit dans l'enceinte sous forme de poudre. Des activateurs couramment utilisés sont les fluorures d'ammonium NH₄F ou d'aluminium AlF₃.

Des secteurs d'anneau 13 à aluminiser, après brasage des structures en nid d'abeilles 16 sur les secteurs de virole 14, sont disposés dans l'enceinte 21 en étant supportés ou suspendus au moyen d'outillages (non représentés). Des blocs de donneur supplémentaires pourront être disposés en regard et à distance des ouvertures des alvéoles.

La température du four est réglée pour que règne à l'intérieur du four une température, généralement comprise entre 950°C et 1200°C, à laquelle un halogénure gazeux se forme par réaction entre le donneur et l'activateur. L'aluminisation est réalisée par dépôt par décomposition de l'halogénure au contact des surfaces des aubes. Le gaz porteur a pour fonction de faciliter le transport des molécules d'halogénure.

Selon un premier mode de mise en oeuvre de l'invention, le gaz porteur utilisé est de l'hélium.

En comparaison avec l'argon, qui est habituellement utilisé, les molécules d'hélium ont un libre parcours moyen nettement supérieur, à pressions égales. Le libre parcours moyen L est usuellement défini comme proportionnel à 1/P.D² où P est la pression et D le diamètre moléculaire. Le rapport L_{He}/L_{Ar} entre les libres parcours moyens des molécules d'hélium et d'argon est environ égal à 3, sous pression atmosphérique.

Grâce à l'allongement du libre parcours moyen des molécules de gaz porteur, la diffusion d'halogénure au sein des alvéoles 17 des secteurs d'anneau 13 est facilitée, de sorte qu'une aluminisation est réalisée, non seulement sur les surfaces externes des secteurs d'anneau, mais aussi sur l'intégralité des parois internes des alvéoles.

Selon un deuxième mode de mise en oeuvre de l'invention, le gaz porteur utilisé est l'argon, mais le processus d'aluminisation est réalisé sous pression réduite de manière également à allonger le libre parcours moyen des molécules de gaz porteur.

Ainsi, après chargement des secteurs d'anneau dans l'enceinte 21 de l'installation de la figure 3, et fermeture étanche du pot 24, l'atmosphère interne du pot 24 et de la boîte 20 est purgée sous argon et la pression est diminuée par pompage à travers la canalisation 26 de manière à amener la pression dans le pot 24 et la boîte 20 à une valeur relativement faible, par exemple inférieure à 5 kPa. Ensuite, un débit continu d'argon est admis à travers la canalisation 30 de manière à maintenir dans le pot 24 et la boîte 20 une pression inférieure à la pression atmosphérique. On choisira pour cette pression une valeur au plus égale à 50 KPa, de préférence au plus égale à 25 kPa, le rapport L_{Ar réd.}/L_{Ar atm}. entre les libres parcours moyen des molécules d'argon à pression réduite et à pression atmosphérique étant alors au moins égal à 2, et de préférence au moins égal à 4.

### Essais

Des secteurs d'anneau de turbine semblables à celui des figures 1 et 2 ont été aluminisés en utilisant une installation du type de celle de la figure 3, le donneur étant un alliage chrome-aluminium à 30-35 % d'aluminium et l'activateur étant AlF₃.

Le processus a été conduit à une température dans l'enceinte 21 égale à environ 1000°C pendant une durée d'environ 5 h.

Trois essais A, B, C ont été réalisés, respectivement avec de l'argon sous pression atmosphérique (procédé d'aluminisation par dépôt en phase vapeur de l'art antérieur), avec de l'hélium et avec de l'argon sous une pression réduite environ égale à 13 kPa.

Pour chaque essai, on a utilisé des structures en nid d'abeilles présentant des alvéoles de hauteurs (profondeurs) H différentes, respectivement 9 mm, 11 mm et 15 mm, et on a mesuré l'épaisseur de dépôt d'aluminisation formé sur les parois internes des alvéoles au voisinage immédiat de leur ouverture (haut), au bas des parois latérales des alvéoles (bas) et sur le fond de celles-ci (fond).

Le tableau ci-dessous indique les épaisseurs mesurées, en µm.

| | | H = 9 mm | H = 11 mm | H = 15 mm |
|---|---|---|---|---|
| A | haut | 46 | 45 | 32 |
| | bas | 0 | 0 | 0 |
| | fond | 0 | 0 | 0 |
| B | haut | 41 | 35 | 34 |
| | bas | 31 | 38 | 23 |
| | fond | 40 | 38 | 19 |
| C | haut | 41 | 29 | 32 |
| | bas | 53 | 34 | 31 |
| | fond | 32 | 26 | 26 |

Alors qu'un revêtement en haut des alvéoles est obtenu dans tous les cas, seuls les procédés réalisés conformément à l'invention ont pu permettre de réaliser un revêtement sur l'intégralité des parois internes des alvéoles, jusqu'au bas et au fond.

On notera que, dans le cas de l'essai C (Ar à pression réduite) le rapport L_{Ar réd.}/L_{Ar atm.} était égal à environ 7,8, tandis que dans le cas de l'essai B (He à pression atmosphérique), le rapport L_{He}/L_{Ar atm.} était égal à environ 3.

Le processus d'aluminisation avec du gaz porteur constitué par l'hélium pourra être réalisé aussi sous pression réduite afin d'avoir un rapport L_{He réd.}/L_{Ar atm.} supérieur à 3 et favoriser encore plus la pénétration des molécules de précurseur jusqu'au bas des alvéoles.

## Revendications

1. Procédé d'aluminisation par dépôt en phase vapeur pour la protection contre l'oxydation à haute température d'une pièce métallique constituée au moins en partie par une structure en nid d'abeilles, procédé selon lequel au moins un précurseur gazeux du dépôt à réaliser comprenant un composé de l'aluminium est amené avec l'aide d'un gaz porteur au contact des surfaces de la pièce disposée dans une enceinte, **caractérisé en ce que** le gaz porteur est choisi parmi l'hélium et l'argon et la pression dans l'enceinte est choisie de manière que le libre parcours moyen des molécules de gaz porteur soit au moins deux fois supérieur à celui des molécules d'argon sous pression atmosphérique.

2. Procédé selon la revendication 1, **caractérisé en ce qu'**il est réalisé sous pression atmosphérique en utilisant l'hélium comme gaz porteur.

3. Procédé selon la revendication 1, **caractérisé en ce qu'**il est réalisé sous une pression inférieure à la pression atmosphérique en utilisant l'hélium comme gaz porteur.

4. Procédé selon la revendication 1, **caractérisé en ce qu'**il est réalisé sous une pression au plus égale à 50 kPa en utilisant l'argon comme gaz porteur.

5. Procédé selon la revendication 1, **caractérisé en ce qu'**il est réalisé sous une pression au plus égale à 25 kPa en utilisant l'argon comme gaz porteur.

6. Procédé selon l'une quelconque des revendications 1 à 5, pour l'aluminisation de secteur d'anneau de turbine basse pression d'une turbomachine, muni d'un revêtement abradable en nid d'abeilles.
